Europäisches Patentamt

European Patent Office

Office européen des brevets

(11) Publication number: **0 032 386**

A2

# (12) EUROPEAN PATENT APPLICATION

(21) Application number: **81100097.5**

(22) Date of filing: **08.01.81**

(51) Int. Cl.³: **H 01 L 21/26**
**H 01 L 29/743**

(30) Priority: **09.01.80 US 110526**

(43) Date of publication of application:
**22.07.81 Bulletin 81/29**

(84) Designated Contracting States:
**BE DE FR GB**

(71) Applicant: WESTINGHOUSE ELECTRIC CORPORATION
Westinghouse Building Gateway Center
Pittsburgh Pennsylvania 15222(US)

(72) Inventor: Tarneja, Kirshan Sukhraj
364 Oakland Avenue
Pittsburgh Pennsylvania(US)

(72) Inventor: Bartko, John
342 Skyview Drive
Monroeville Pennsylvania(US)

(74) Representative: Fleuchaus, Leo, Dipl.-Ing. et al,
Fleuchaus & Wehser Melchiorstrasse 42
D-8000 München 71(DE)

(54) A method for tailoring forward voltage drop (VTM) switching time (tq) and reverse-recovery charge (Qrr) in a power thyristor using nuclear particle and electron irradiation.

(57) A method for improving the relationship of reverse recovery charge Qrr, reverse recovery time tq, and forward voltage drop VTM comprises the steps of irradiating the thyristor with a first predetermined dosage of light ions, preferably alpha or proton particles and then irradiating the thyristor with a second predetermined dosage of electron particles.

FIG. 2

EP 0 032 386 A2

1

# A METHOD FOR TAILORING FORWARD VOLTAGE DROP ($V_{TM}$) SWITCHING TIME ($t_q$), AND REVERSE-RECOVERY CHARGE ($Q_{rr}$) IN A POWER THYRISTOR USING NUCLEAR PARTICLE AND ELECTRON IRRADIATION

This invention relates to methods for irradiating semiconductors, and in particular to methods for creating low-lifetime regions in semiconductor thyristors.

For many applications, power thyristors are needed which have fast switching speeds, that is low switching times ($t_q$), low levels of reverse-recovery charge ($Q_{rr}$), and low levels of forward voltage drop ($V_{TM}$). There are techniques available for obtaining good $V_{TM}$ - $t_q$ characteristics, for example, 2 to 17 MeV nuclear particle irradiation, including proton or alpha particles irradiation. Similarly, electron irradiation at 1.5 MeV or higher is a very effective technique for obtaining good $V_{TM}$-$Q_{rr}$ characteristics. However, the nuclear particle irradiation provides $V_{TM}$-$Q_{rr}$ characteristics inferior to that provided by electron irradiation and, conversely, electron irradiation provides $V_{TM}$-$t_q$ characteristics inferior to that provided by nuclear particle irradiation.

There exists a need for a method for obtaining consistently low parameter values. It would also be desirable to have a technique for providing different combinations of $V_{TM}$-$t_q$ and $V_{TM}$-$Q_{rr}$ characteristics for each device.

Radiation of thyristors by electrons is well known in the prior art e.g., U.S. Patent No. 4,075,037, and also the radiation by nuclear particles, e.g., U.S. Patent No. 4,056,408.

The principal object of the invention is to provide an improved relationship between the reverse recovery charge, the reverse recovery time and the forward voltage drop of a thyristor.

One aspect of the emotion resides broadly in a a method of making a thyristor having emitter, emitter base, cathode base and cathode regions, said method comprising the steps of: irradiating a thyristor wafer with electron radiation characterized in that said wafer is irradiated by nuclear radiation thereby adopting the relation between the reverse recovery charge, forward voltage drop and switching time.

Another aspect of the invention resides broadly in a thyristor having an emitter, emitter base, cathode base irradiated by electron radiation characterized in that said irradiated emitter base (24) has a region (30) of change in the original structure which has a substantially higher resistivity formed by nuclear radiation.

More specifically, the thyristor is irradiated with a dosage of light (atomic weight) ions having a well-defined range of penetration into the thyristor for creating a narrow low-lifetime semiconductor region in the p-base of the thyristor near the forward-blocking p-n junction. The thyristor is then irradiated with a dosage of electron particles, for reducing the lifetime of the n-base of the thyristor.

A preferred embodiment of the invention is shown by way of example only with the aid of the following drawings:

Figure 1 is a sectional view of an unirradiated thyristor, the characteristics of which can be modified by the method of the present invention;

Figure 2 is a sectional view of the thyristor of Figure 1 after it has been exposed to alpha radiation;

Figures 3, 4, and 5 are graphs of curves of the trade offs between pertinent performance parameters of the thyristor of Figure 1; and

Figure 6 is a sectional view of the thyristor of Figure 1 after it has been exposed to electron irradiation.

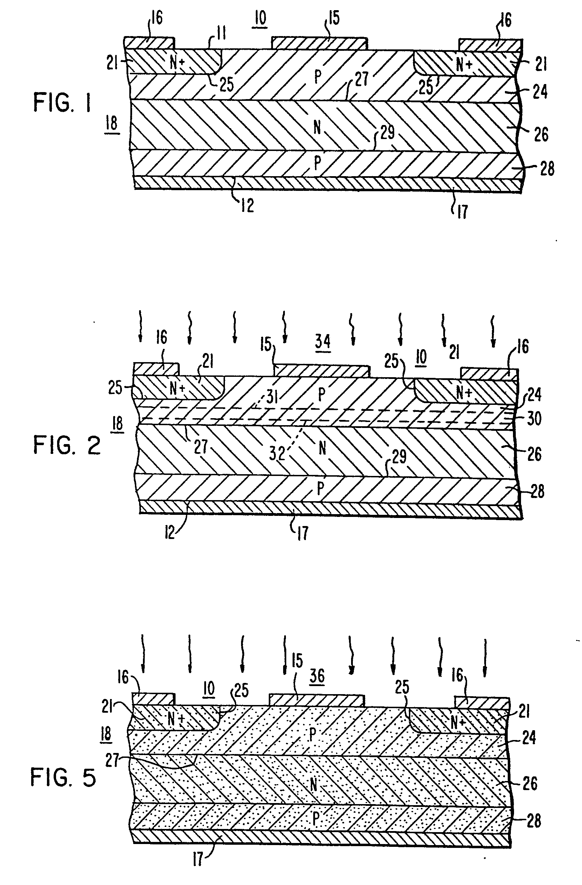

Figure 1 shows, by way of example, a sectional view of thyristor 10 the characteristics of which can be modified according to the method of the present invention. The thyristor 10 is unirradiated and can be, for example, of the type sold commercially under the designation T72NCB.

The thyristor 10 comprises a body of semiconductor material 18 between a top surface 11 and a bottom surface 12. The body of semiconductor material 18 includes a layer 21 of semiconductor material adjacent to the top surface 11, which layer 21 having an n-type conductivity and having a high impurity concentration of approximately $10^{21}$ donor atoms/cm$^3$. An n-type layer such as the layer 21 having such a high impurity concentration is commonly referred to as an $n^+$-type impurity layer. The body 18 also includes a 70 μm thick layer 24 of semiconductor material adjacent to the layer 21 and forming a p-n junction 25 therewith. The layer 24 is characterized by a p-type conductivity and by an impurity concentration of about $10^{17}$ acceptor atoms/cm$^3$. A layer 26 of semiconductor material is disposed adjacent to the layer 24 and forms a p-n junction 27 therewith. The layer 26 is characterized by an n-type conductivity and by an impurity concentration of about $10^{14}$ donor atoms/cm$^3$. A layer 28 of semiconductor material is disposed adjacent to the layer 26 and the bottom surface 12 and forms a p-n junction 29 with the layer 26. The layer 28 is characterized by a p-type conductivity and by an impurity concentration

of about $10^{21}$ acceptor atoms/cm$^3$.

The thyristor 10 also includes a disc-shaped gate electrode 15 disposed over the center thereof on the top surface 11. Also disposed on the top surface 11 and concentric with the gate electrode 15 is a ring-shaped cathode electrode 16. A disc-shaped anode electrode 17 is disposed on the bottom surface 12.

According to the preferred embodiment of the method of the present invention, the thyristor 10 can be irradiated with a dosage of alpha particles having an energy of about 10.2 MeV for creating a low-carrier lifetime region 30 having high resistivity in the layer 24 having a maximum thickness of about 5 μm as shown in Figure 2. The dosage of alpha particles may be derived from any conventional source. For example, a tandem Van de Graaff accelerator is capable of providing a beam 34 of alpha particles of suitable energy and concentration. The dosage is a function of time and is measured in units of particles • seconds per square centimeter (s/cm$^2$). The beam 34 is described as a beam of alpha particles but may be any kind of subatomic particle which causes crystal lattice dislocations within a well-defined range of distances within the thyristor 10. For example, any of the light ions such as proton particles or boron particles may be used as an alternative to alpha particles as convenience and economy may prescribe.

The region 30 is characterized by top and bottom boundaries designated by dashed lines 31 and 32, respectively, such that the line 32 is approximately 20 μm from the p-n junction 27. It is preferred that the region 30 be as narrow as possible, actually, with the theoretical minimum width being about 2-3 μm and the practical minimum width being about 5 μm. In any case, the maximum preferred width of the region 30 is 5 μm. The minimum thickness of the low-carrier-lifetime region 30 in the p-base is determined by the multiple scattering or "straggling" of the light ion particles. It is contemplated that the thyristor is irradiated by a monoenergetic beam of particles so as to achieve the minimum possible thickness. As a practical matter, however, most irradiation will have some minimal spread or deviation around a central measure of energy. It is also preferred that the region 30 be spaced apart from the p-n junction 27 such that the boundary 32 is approximately 20 μm therefrom; at least in the thyristor 10. If the region 30 is in closer proximity to the p-n junction 27, a depletion region extending into the semiconductor layer 24 may extend into the region 30 and causes increased leakage current. In general, a depletion region surrounding the p-n junction 27 extends into the semiconductor layer 24 a distance determined, in part, by the blocking voltage which the p-n junction 27 is required to support; the greater the blocking voltage across the p-n junction 27, the farther a depletion region will extend into the semiconductor layer 24. Therefore, the region 30 can be closer to the p-n junction 27 so long as a depletion region formed by an blocking voltage applied to the thyristor 10 will not extend into the region 30. On the other hand, the region 30 should be as close to the p-n junction 27 as possible or more accurately as far from the surface 11 as possible since for a given switching time $t_q$, the forward voltage drop increases more rapidly the closer the region 30 is to the surface 11.

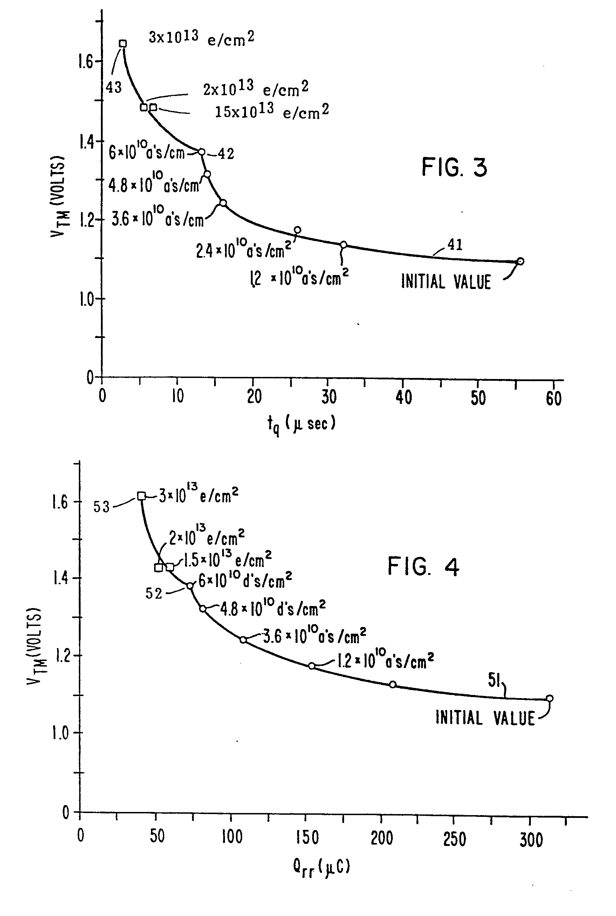

Figure 3 shows a graph having switching time, $t_q$, as an abscissa calibrated in units of μsec and having forward voltage drop, $V_{TM}$, as an ordinate calibrated in units of volts. A curve 41 shows the $t_q$-$V_{TM}$ trade-off for various cumulative dosages of alpha particle irradiation. In general, as can be seen from Figure 3 and curve 41, as the cumulative alpha particle dosage increases, $t_q$ decreases (generally desirable) and $V_{TM}$ increases (generally undesirable). Figure 4 shows a graph having reverse-

recovery charge, $Q_{rr}$, as an abscissa calibrated in units of microcoulombs (μC) and having $V_{TM}$ as an ordinate calibrated in units of volts. A curve 51 shows the $Q_{rr}$-$V_{TM}$ trade off for various cumulative dosages of alpha particle irradiation. In general, as can be seen from Figure 4 and curve 51, as the cumulative alpha particle dosage increases, $Q_{rr}$ decreases (generally desirable) and $V_{TM}$ increases (generally undesirable).

The dosage of alpha particle irradiation to which the thyristor 10 is exposed may vary from as low as $5 \times 10^9$ particles • s/cm$^2$ to as high as possible. Though the above irradiation dosage limits are not immutable, any dosage lower than $5 \times 10^9$ particles • s/cm$^2$ will only negligibly lower $Q_{rr}$ and $t_q$. Moreover, the upper irradiation dosage limit will depend upon the particular device parameters desired and the trade-offs between parameters a designer is willing to make.

By way of example, the thyristor 10 is irradiated with the beam 34 which consists of a dosage of $6 \times 10^{10}$ alpha particles • s/cm$^2$. The thyristor 10 is characterized before the irradiation by the parameters $t_q$ = 55 μs; $Q_{rr}$ = 310 μC; and $V_{TM}$ = 1.1V. After the irradiation, the thyristor 10 is characterized by the parameters $t_q$ = 14 μs; $Q_{rr}$ = 75 μC; and $V_{TM}$ = 1.38V; as can be seen at a point 42 on the curve 41 and at a point 52 on the curve 51.

According to the preferred embodiment of the method of the present invention, after the thyristor 10 is irradiated with a dosage of alpha particle as described above, the thyristor 10 is then irradiated with a dosage of electrons having an energy of about 2 MeV for generally lowering the carrier lifetime characteristic of the n-base region 26 of the thyristor 10 as shown in Figure 6. The dosage of electrons may be derived from any conventional source. For example, a Van de Graaff accelerator is capable of providing a beam 36 of electrons of suitable energy and concentration. The dosage of electrons is measured in units of (electrons (e)/cm$^2$). The beam 36 is described as a beam of electrons but may include any type of radiation for example, gamma ray radiation which causes crystal lattice dislocations uniformly within the n-base region 26.

The dosage of electron irradiation to which the thyristor 10 is exposed may vary from as low as 5 x 10$^{12}$ e/cm$^2$ to as high as 10$^{14}$ e/cm$^2$ depending upon the desired device parameters and the trade-offs the designer is willing to make.

Continuing the above example, after the thyristor 10 is irradiated with 6x10$^{10}$ alpha particles • s/cm$^2$, the thyristor 10 is then irradiated with the beam 36 which consists of a dosage of 3x10$^{13}$ e/cm$^2$. Before the electron irradiation but after the alpha particle irradiation, the thyristor 10 is characterized by the parameters $t_q$ = 14 µs: $Q_{rr}$ = 75 µC: and $V_{TM}$ = 1.38V as detailed hereinabove with reference to the alpha particle irradiation and as shown at the points 42 and 52 of Figures 3 and 4, respectively. After the electron irradiation, the thyristor 10 is characterized by the parameters $t_q \cong$ 5 µs; $Q_{rr}$ = 40 µC: and $V_{TM}$ = 1.62V as shown by points 43 and 53 of Figures 3 and 4, respectively.

While the invention has been described in its preferred embodiment, it is to be understood that the words which have been used are words of description not words of limitation and that changes may be made within the purview of the appended claims without departing from the true scope and spirit of the invention in its broader aspects.

It will be appreciated by those skilled in the art that the present invention may be carried out in various ways and may take various forms and embodiments other than the illustrative embodiments heretofore described. For example, it is contemplated that any method may be used to reduce the carrier lifetime in the region 30 so long as the method used does not substantially modify the carrier lifetime of the remainder of the semiconductor layer 24. Also, any method may be used to reduce the lifetime of the n-base 26 so long as the method used does not substantially modify the carrier lifetime of the remainder of the thyristor 10. Moreover, it is contemplated that the sequence of irradiation or, generally, the sequence in which the lifetimes are reduced in the region 30 and the layer 26 can be reversed or indeed the lifetimes may be reduced simultaneously and still be within the scope of the description and claims of the present invention.

Since still other variations could be recited, it is to be understood that the scope of the invention is not limited by the details of the foregoing description but will be defined in the following claims.

9

What we claim is:

1.  A method of making a thyristor having emitter, emitter base, cathode base and cathode regions, said method comprising the steps of:

irradiating a thyristor wafer with electron radiation characterized in that said wafer is irradiated by nuclear radiation thereby adopting the relation between the reverse recovery charge, forward voltage drop and switching time.

2.  A method according to claim 1 characterized in that the energy level of the nuclear radiation is chosen such as to generate a region of change of the original structure in said emitter base.

3.  A method according to claim 2 characterized in that said region of change comprises a region having higher resistivity than said original structure.

4.  A method according to claim 2 or 3 characterized in that said nuclear energy level is determined to place said region of change having a specified thickness at a specified position in the emitter base.

5.  A method according to any of the preceding claims characterized in that said nuclear radiation is proton radiation.

6.  A method according to any of claims 1 through 4 characterized in that said nuclear radiation is alpha particle radiation.

7.  A thyristor having an emitter, emitter base, cathode base irradiated by electron radiation characterized in that said irradiated emitter base (24) has a region (30) of change, formed by nuclear radiation, in the original structure which has a substantially higher resistivity than said original structure.

FIG. 1

FIG. 2

FIG. 5

FIG. 3

FIG. 4